# EUROPEAN PATENT APPLICATION

(11) **EP 4 494 813 A1**
(43) Date of publication of application: **22.01.2025**
(21) Application number: 23770274.1
(22) Date of filing: 20.02.2023
(51) Int. Cl.: B24D 3/32, B24B 37/24, B24D 3/00, B24D 11/00, H01L 21/304

(54) **POLISHING PAD, METHOD FOR MANUFACTURING POLISHING PAD, AND WAFER POLISHING METHOD**

(30) Priority: 17.03.2022 JP 2022043157
(71) Applicant: Noritake Co., Limited, Nagoya-shi, Aichi 451-8501 (JP)
(72) Inventor: ITO, Ryoma, Nagoya-shi, Aichi 451-8501 (JP); KISHIMOTO, Masatoshi, Nagoya-shi, Aichi 451-8501 (JP)
(74) Representative: Viering, Jentschura & Partner mbB Patent- und Rechtsanwälte
(86) International application number: PCT/JP2023/005902
(87) International publication number: WO 2023/176315

(57) **Abstract**

Provided is a polishing pad that enables facilitating quality control of a polishing liquid, eliminating or simplifying a process for cleaning polished wafers, facilitating treatment of the polishing liquid that has been used for polishing wafers, and obtaining a high surface quality of the polished wafers and a high polishing rate. A polishing pad 10 of the present invention includes: a base material 12 made of a base resin and having a plurality of pores 14 formed therein; and polishing particles 16 held in the base material 12 or the pores 14. When any specific pores are selected from the pores, and a short diameter, which is the shortest inner diameter of each of the specific pores, and a long diameter, which is the longest inner diameter thereof, are defined, pore-related areas, each of which is calculated by multiplying the short diameter, the long diameter, pi and 1/4, have an average value of 87.7 µm² or more. The polishing particles 16 are silica particles with a specific surface area of 8.9 to 10.5 m²/g.

## Description

### TECHNICAL FIELD

The present invention relates to a polishing pad, a polishing pad manufacturing method, and a wafer polishing method.

### BACKGROUND ART

Wafer polishing apparatuses are known, each of which includes a surface plate and a carrier. The surface plate has a fixing surface extending in a direction perpendicular to an axis, and is rotated around the axis. The carrier holds a flat plate-shaped wafer such that the wafer is rotatable relative to the surface plate.

When a flat plate-shaped wafer made of Si, SiC, GaN, etc. is polished with such a wafer polishing apparatus, a polishing pad is fixed to the fixing surface of the surface plate. Then, the surface plate and the carrier are rotated relative to each other while the polishing pad and the wafer are in contact with each other at a predetermined surface pressure in presence of a polishing liquid. When the polishing liquid contains a chemical such as an alkali, the wafer is polished in a chemical mechanical polishing (CMP) process.

When the polishing pad is made of materials such as a general nonwoven fabric or hard urethane that contains no polishing particles, the polishing liquid contains polishing particles. In this case, it is necessary to perform quality control of the polishing liquid, and it is also necessary to clean the polished wafer. In addition, such a polishing liquid is expensive, and therefore it is necessary to collect the polishing liquid that has been used for polishing the wafer, recycle it to a predetermined state, and reuse it. Furthermore, when the used polishing liquid or a cleaning liquid for cleaning the polished wafer is discarded, the liquid must be treated complexly so as not to harm the environment. Consequently, in this case, the manufacturing cost of semiconductor apparatuses increases and the environmental impact is high.

In contrast, as disclosed in Patent Literatures 1 to 3, when a polishing pad includes: a base material made of a base resin and having a plurality of pores formed therein; and polishing particles held in the base material or in the pores, a polishing liquid that contains no polishing particles is employable. In this case, quality control of the polishing liquid is unnecessary or easy, and the process for cleaning the polished wafer is eliminated or simplified. In addition, such a polishing liquid is inexpensive, and therefore it is not necessarily required to collect and reuse the polishing liquid that has been used for polishing the wafer. Furthermore, when the used polishing liquid is discarded, the liquid is not required to be treated complexly. Consequently, in this case, it is possible to lower the manufacturing cost of semiconductor apparatuses and to reduce the environmental impact.

### CITATION LIST

### PATENT LITERATURE

Patent Literature 1: Japanese Patent No. 4266579
Patent Literature 2: Japanese Patent No. 5511266
Patent Literature 3: Japanese Patent No. 6636634

### SUMMARY OF INVENTION

### TECHNICAL PROBLEM

However, in the wafer polishing process, a high surface quality of the polished wafer and a high polishing rate are desirable.

The present invention was conceived considering the aforementioned previously-existing circumstances, and it is an object to be achieved thereby to provide a polishing pad that enables facilitating quality control of a polishing liquid, eliminating or simplifying a process for cleaning polished wafers, facilitating treatment of the polishing liquid that has been used for polishing wafers, and obtaining a high surface quality of the polished wafers and a high polishing rate. It is another object to be achieved by the present invention to provide a method for manufacturing the polishing pad. Furthermore, it is still another object to be achieved by the present invention to provide a wafer polishing method using the polishing pad.

### SOLUTION TO PROBLEM

A polishing pad of the present invention is used in a wafer polishing apparatus including: a surface plate having a fixing surface that extends in a direction perpendicular to an axis and being rotated around the axis; and a carrier holding a flat plate-shaped wafer such that the wafer is rotatable relative to the surface plate,
the polishing pad is fixed to the fixing surface and polishes the wafer at a predetermined surface pressure in presence of a polishing liquid, comprising:
a base material made of a base resin and having a plurality of pores formed therein; and polishing particles held in the base material or in the pores, wherein:
when any specific pores are selected from the pores, and a short diameter, which is the shortest inner diameter of each of the specific pores, and a long diameter, which is the longest inner diameter thereof, are defined,
pore-related areas, each of which is calculated by multiplying the short diameter, the long diameter, pi and 1/4, have an average value of 87.7 µm² or more, and
the polishing particles are silica particles with a specific surface area of 8.9 to 10.5 m²/g.

The polishing pad of the present invention includes: the base material made of the base resin and having the plurality of the pores formed therein; and the polishing particles held in the base material or in the pores. This allows employing a polishing liquid that contains no polishing particles. This then enables facilitating quality control of the polishing liquid and eliminating or simplifying a process for cleaning polished wafers. In addition, such a polishing liquid is inexpensive, and therefore it is not necessarily required to collect and reuse the polishing liquid that has been used for polishing wafers. Furthermore, when the used polishing liquid is discarded, the liquid is not required to be treated complexly.

To obtain a high surface quality of the polished wafers, it is common to use fine polishing particles. In contrast, it is considered that a high polishing rate cannot be obtained if fine polishing particles are used, and a high polishing rate cannot be obtained unless coarse polishing particles are used. To solve these generally conflicting problems, the inventors focused on the surface area of pores formed by the base material and the specific surface area of the polishing particles. Then, the inventors obtained an optimal polishing pad by variously adjusting pore-related areas, which are associated with the surface area of the pores, and the specific surface area of the polishing particles, thereby completing the present invention.

In other words, the inventors selected any specific pores from the pores, defined a short diameter, which is the shortest inner diameter of each of the specific pores, and a long diameter, which is the longest inner diameter thereof, and determined the pore-related areas, each of which is calculated by multiplying the short diameter, the long diameter, pi and 1/4. According to the inventors' tests, if the pore-related areas have an average value of 87.7 µm² or more, and silica particles with a specific surface area of 8.9 to 10.5 m²/g are employed as the polishing particles, it is possible to obtain a high surface quality of the polished wafers and a high polishing rate.

Therefore, use of the polishing pad of the present invention in the aforementioned wafer polishing apparatus enables facilitating quality control of the polishing liquid, eliminating or simplifying the separate cleaning process, facilitating treatment of the polishing liquid that has been used for polishing wafers, and obtaining a high surface quality of the polished wafers and a high polishing rate. This enables further lowering the manufacturing cost of semiconductor apparatuses and reducing the environmental impact.

A polishing pad manufacturing method of the present invention comprises:
a first step of preparing a paste containing a base resin, polishing particles, and a solvent;
a second step of forming the paste into a sheet-shaped formed body;
a third step of immersing the formed body in a replacement liquid and replacing the solvent in the formed body with the replacement liquid to obtain a replaced body; and
a fourth step of removing the replacement liquid from the replaced body to obtain a polishing pad that includes: a base material made of the base resin and having a plurality of pores formed therein; and polishing particles held in the base material or in the pores, wherein:
   the polishing particles are silica particles with a specific surface area of 8.9 to 10.5 m²/g, and
   when any specific pores are selected from the pores, and a short diameter, which is the shortest inner diameter of each of the specific pores, and a long diameter, which is the longest inner diameter thereof, are defined,
   proportions of the base resin, the polishing particles, and the solvent are adjusted in the first step such that pore-related areas, each of which is calculated by multiplying the short diameter, the long diameter, pi and 1/4, have an average value of 87.7 µm² or more.

The manufacturing method of the present invention enables manufacturing the polishing pad of the present invention. The inventors used N-methyl-2-pyrrolidone (NMP) as the solvent and water as the replacement liquid, and confirmed that the polishing pad of the present invention is manufacturable by the manufacturing method of the present invention.

A wafer polishing method of the present invention comprises polishing a flat plate-shaped wafer by rotating the wafer and a flat plate-shaped polishing pad relative to each other around an axis that extends in a thickness direction of the wafer while the wafer and the polishing pad are in contact with each other at a predetermined surface pressure in presence of a polishing liquid, wherein:
the polishing pad includes: a base material made of a base resin and having a plurality of pores formed therein, and polishing particles held in the base material or in the pores,
when any specific pores are selected from the pores, and a short diameter, which is the shortest inner diameter of each of the specific pores, and a long diameter, which is the longest inner diameter thereof, are defined,
pore-related areas, each of which is calculated by multiplying the short diameter, the long diameter, pi and 1/4, have an average value of 87.7 µm² or more, and
the polishing particles are silica particles with a specific surface area of 8.9 to 10.5 m²/g.

The wafer polishing method of the present invention uses the polishing pad of the present invention, thus enabling further lowering the manufacturing cost of semiconductor apparatuses and reducing the environmental impact.

### ADVANTAGEOUS EFFECTS OF INVENTION

Use of the polishing pad of the present invention enables facilitating quality control of the polishing liquid, eliminating or simplifying the separate cleaning process for cleaning the polished wafers, facilitating treatment of the polishing liquid that has been used for polishing wafers, and obtaining a high surface quality of the polished wafers and a high polishing rate. The manufacturing method of the present invention enables manufacturing the polishing pad of the present invention. The wafer polishing method of the present invention enables further lowering the manufacturing cost of semiconductor appratuses and reducing the environmental impact.

### BRIEF DESCRIPTION OF DRAWINGS

[FIG. 1] FIG. 1 is an enlarged schematic cross-sectional view of a polishing pad of Working Examples 1 to 3.
[FIG. 2] FIG. 2 is an enlarged schematic cross-sectional view of a polishing pad of Comparative Examples 1 and 2.
[FIG. 3] FIG. 3 is a graph showing a relationship between average particle diameters and specific surface areas of silica particles used in Working Examples 1 to 3 and Comparative Examples 1 and 2.
[FIG. 4] FIG. 4 is a schematic cross-sectional view of a wafer polishing apparatus used in a wafer polishing method.

### DESCRIPTION OF EMBODIMENTS

According to tests conducted by the inventors, any of pore-related areas has preferably a maximum value of 209.3 µm² or more and a minimum value of 29.3 µm² or more.

As a base resin used to manufacture a polishing pad, polyethersulfone (PES), polyvinylidene fluoride (PVDF), polyvinyl fluoride, a vinyl fluoride/hexafluoropropylene copolymer, a vinylidene fluoride/hexafluoropropylene copolymer, polyethylene, polymethyl methacrylate, or the like is employable. These may be used singly or may be used in a mixture of two or more kinds thereof. The inventors have confirmed effects when the base resin is PES.

As a solvent used to manufacture the polishing pad, N-methyl-2-pyrrolidone (NMP), N-ethyl-2-pyrrolidone (NEP), dimethylformamide, dimethyl sulfoxide, acetone, ethyl acetate, methyl ethyl ketone methyl ethyl ketone, or the like is employable. These may be used singly or may be used in a mixture of two or more kinds thereof. Various solvents are selected according to the base resin.

As polishing particles, in addition to silica particles, alumina particles, ceria particles, diamond particles, or the like are usable, but these may have various unknown properties that may affect the polishing pad, such as each having a different specific gravity or having different properties that affect the base resin. Therefore, it is expected that using any of the above polishing particles other than the silica particles will cause different matching ranges of the pore-related areas and the specific surface area of the polishing particles.

A paste used to manufacture the polishing pad contains the base resin, the polishing particles and the solvent, and may contain alkali fine particles, such as sodium carbonate, piperazine, potassium hydroxide, sodium hydroxide, calcium oxide, potassium carbonate, and magnesium oxide. The paste may also contain a water repellent, such as a fluorine-based water repellent, a silicon-based water repellent, a hydrocarbon-based water repellent, or a metal compound-based water repellent. Furthermore, the paste may contain a pigment such as an inorganic pigment, including titanium dioxide, calcium carbonate or carbon black, or an organic pigment, including an azo pigment or a polycyclic pigment. These may be used singly or may be used in a mixture of two or more kinds thereof.

In a method for manufacturing the polishing pad, when an oil-based solvent is employed as a replacement liquid to replace the solvent, an aqueous liquid such as tap water is employable.

When a polishing liquid is used, the polishing liquid may be pure water, may be oil-based, or may contain an acidic or alkaline chemical.

### (Working Examples and Comparative Examples)

Working Examples 1 to 3 embodying the present invention and Comparative Examples 1 to 3 are described below.

Firstly, in a first step, a base resin, polishing particles, and a solvent, which are described below, were prepared.
(Base resin)
   PES
(Polishing particles)
   Silica (SiO₂) particles
(Solvent)
   NMP

In the first step, 30 parts by volume of the base resin, 48 parts by volume of the solvent, and 22 parts by volume of the polishing particles were mixed to obtain a paste of each of Working Examples 1 to 3 and Comparative Examples 1 to 3. At this time, as shown in Table 1, silica particles having different specific surface areas (m²/g) and different average particle diameters (µm) were used in Working Examples 1 to 3 and Comparative Examples 1 to 3. A Mastersize manufactured by Malvern was used to measure the average particle diameters of the silica particles.

**[Table 1]**

| | Working Example 1 | Working Example 2 | Working Example 3 | Comparative Example 1 | Comparative Example 2 | Comparative Example 3 |
|---|---|---|---|---|---|---|
| Specific surface area (m²/g) | 8.9 | 10.2 | 10.5 | 5.6 | 8.3 | 11.1 |
| Average particle diameter [µm] | 0.75 | 0.66 | 0.56 | 0.92 | 0.81 | 0.54 |

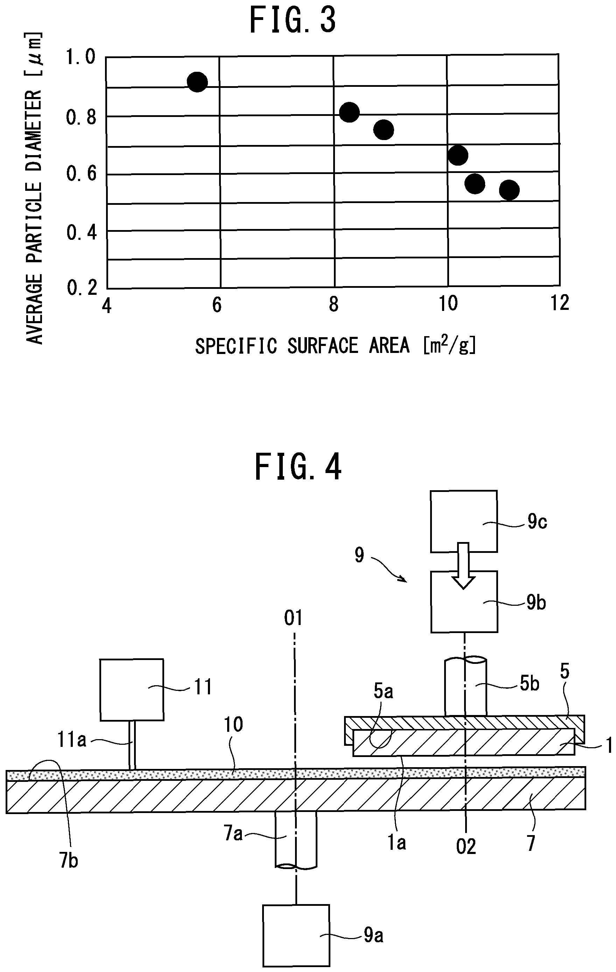

FIG. 3 shows a relationship between the average particle diameters and the specific surface areas of the silica particles used in Working Examples 1 to 3 and Comparative Examples 1 to 3. As shown in FIG. 3, a correlation is found between the specific surface areas and the average particle diameters of the silica particles.

In a second step, each paste obtained in the aforementioned first step is formed into a sheet-shaped formed body with a forming apparatus such as a T-die. The forming method is not limited to this method as long as thicknesses of the formed bodies are made uniform to some extent.

In a third step, each formed body was immersed in tap water, which serves as a replacement liquid, in a predetermined period, was taken out from the tap water and dried to obtain a solidified body. A front surface of each solidified body was ground to a predetermined thickness to obtain a polishing pad 10 with a diameter of 30 cm. Each polishing pad 10 is not provided with a groove pattern. It is noted that, in Comparative Example 3, because the silica particles were too fine and thus easily aggregated, no testable polishing pad 10 was obtained.

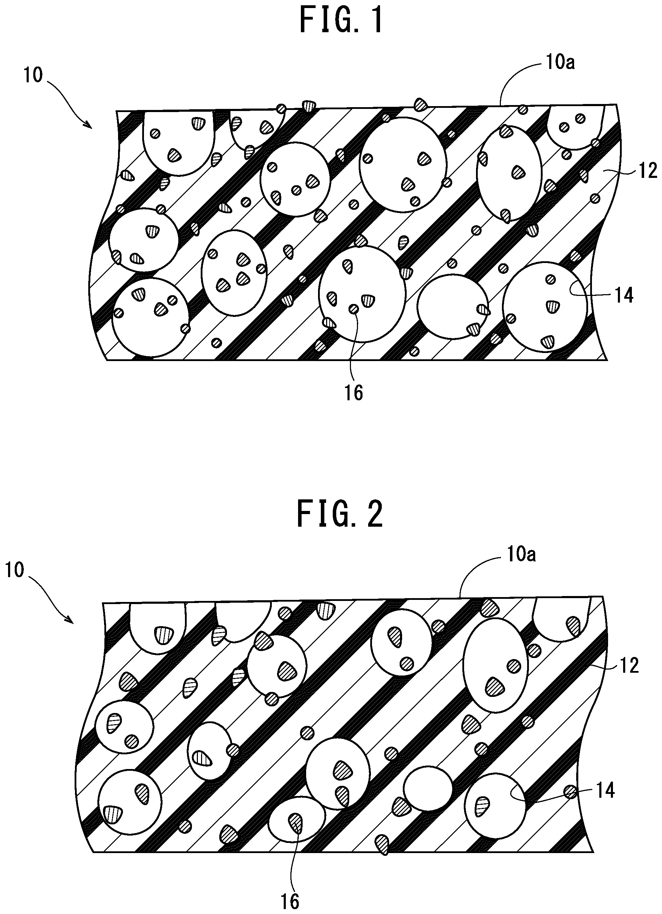

FIG. 1 shows an enlarged schematic cross-sectional view of the polishing pad of Working Examples 1 to 3, and FIG. 2 shows an enlarged schematic cross-sectional view of the polishing pad of Comparative Examples 1 and 2.

As shown in FIG. 1 and FIG. 2, each polishing pad 10 includes: a base material 12 made of the base resin and having a plurality of pores 14 formed therein; and silica particles 16 held in the base material 12 or in the pores 14. Some of the pores 14 and some of the silica particles 16 are partially exposed on a polishing surface 10a located on the front surface of the polishing pad 10. As can be seen by comparing FIG. 1 and FIG. 2, the polishing pads 10 of Working Examples 1 to 3 have the pores 14 that are moderately large and the silica particles 16 that are moderately fine, compared with the polishing pads 10 of Comparative Examples 1 and 2.

In a SEM image at 5000x magnification of the polishing surface 10a of the polishing pad 10, when any specific pores were selected from the pores 14, and a short diameter a, which is the shortest inner diameter of each of the specific pores, and a long diameter b, which is the longest inner diameter thereof, were defined, pore-related areas (µm²), each of which is calculated by multiplying the short diameter a, the long diameter b, pi (π) and 1/4, were determined.

In each of Working Examples 1 to 3 and Comparative Examples 1 and 2, 20 specific pores were selected on the polishing surface 10a of the polishing pad 10, and the pore-related areas were determined. Table 2 shows a maximum value, a minimum value and an average value of the pore-related areas associated with the polishing surface 10a of each polishing pad 10.

**[Table 2]**

| | Working Example 1 | Working Example 2 | Working Example 3 | Comparative Example 1 | Comparative Example 2 | Comparative Example 3 |
|---|---|---|---|---|---|---|
| Maximum value | 209.3 | 321.4 | 335.1 | 46.0 | 75.3 | Indeterminable |
| Minimum value | 29.3 | 33.5 | 32.9 | 6.3 | 7.5 | Indeterminable |
| Average value | 87.7 | 94.7 | 95.6 | 24.2 | 27.0 | Indeterminable |

As shown in Table 2, for the polishing surface 10a of the polishing pad 10 in each of Working Examples 1 to 3, the pore-related areas have an average value of 87.7 µm² or more, and any thereof has a maximum value of 209.3 µm² or more and a minimum value of 29.3 µm² or more. In contrast, for the polishing pad 10 in each of Comparative Examples 1 and 2, the pore-related areas have an average value of 27.5 µm² or less, and any thereof has a maximum value of 75.3 µm² or less and a minimum value of 7.5 µm² or less.

As shown in FIG. 4, a wafer polishing apparatus (Engis EJW-380), which uses a wafer 1 as a body to be polished, was prepared, and the wafer 1 was polished with the polishing pad 10 of each of Working Examples 1 to 3 and Comparative Examples 1 and 2. The wafer polishing apparatus includes a plurality of carriers 5, a surface plate 7, a drive device 9, and a polishing liquid supply device 11. Although only one of the carriers 5 is shown in FIG. 4, the wafer polishing apparatus has the plurality of the carriers 5. Each carrier 5 has a horizontal disc shape. A second fixing surface 5a is provided, being recessed in a lower surface of each carrier 5, and the second fixing surface 5a is configured to fix the wafer 1 thereon. A carrier rotating shaft 5b is provided, protruding vertically from an upper surface of each carrier 5. Each wafer 1 is a 4H-SiC single crystal with a diameter of 4 inches. A polished surface 1a, which is the Si surface of each wafer 1, faces downward.

The surface plate 7 has a horizontal disc shape that encloses all the carriers 5. A surface plate rotating shaft 7a is provided, protruding vertically from a lower surface of the surface plate 7. An upper surface of the surface plate 7 is a first fixing surface 7b. The disc-shaped polishing pad 10 is fixed to the first fixing surface 7b with an adhesive so as to face each wafer 1. A center line O of the polishing pad 10 is aligned with a first axis O1.

The drive device 9 has a main drive unit 9a, a sub drive unit 9b, and a pressurizing unit 9c. The main drive unit 9a rotates the surface plate rotating shaft 7a around the first axis O1 at a predetermined speed. The sub drive unit 9b rotates each carrier rotating shaft 5b around a second axis O2 at a predetermined speed. The pressurizing unit 9c applies pressure to each carrier rotating shaft 5b and the sub drive unit 9b toward the surface plate 7 with a predetermined load.

The polishing liquid supply device 11 is provided above the surface plate 7. The polishing liquid supply device 11 interposes a polishing liquid 11a between each wafer 1 and the polishing pad 41. In a polishing method of Working Examples 1 to 3 and Comparative Examples 1 and 2, the polishing liquid 11a that is made of an aqueous potassium permanganate solution and contains no polishing particles was used.

In the wafer polishing apparatus, each wafer 1 was polished under the following conditions.
Flow rate of the polishing liquid 11a: 10 mL/min
Load: 30 kPa
Rotation speed of the surface plate 7: 60 rpm
Rotation speed of the carriers 5: 60 rpm
Processing time: 60 minutes

A polishing rate (nm/hour) and a surface roughness Sa (nm) of the polished wafer 1 were evaluated. The BW-D501 model manufactured by Nikon Corporation was used to measure the surface roughness Sa. The results are shown in Table 3.

**[Table 3]**

| | Working Example 1 | Working Example 2 | Working Example 3 | Comparative Example 1 | Comparative Example 2 | Comparative Example 3 |
|---|---|---|---|---|---|---|
| Polishing rate | 1100 | 1120 | 1155 | 700 | 770 | Polishing impossible |
| Surface roughness (Sa) | 0.095 | 0.092 | 0.092 | 0.094 | 0.090 | Polishing impossible |

Table 3 shows that the polishing pad 10 of each of Working Examples 1 to 3 polishes the wafer 1 to the same level of the surface roughness Sa as the polishing pads 10 of Comparative Examples 1 and 2 at a higher polishing rate than the polishing rates of the polishing pads 10 of Comparative Examples 1 and 2. This is because, for the polishing pad 10 of each of Working Examples 1 to 3, the average value of the pore-related areas is 87.7 µm² or more, and the specific surface area of the silica particles 16 is in a range from 8.9 to 10.5 m²/g. It is presumed that the surface area of the pores 14 and the specific surface area of the silica particles 16 were appropriately matched, and the silica particles 16 were likely to be supplied enough to the polishing surface 10a during the polishing process, resulting in the higher polishing rate.

In contrast, for the polishing pad 10 of each of Comparative Examples 1 and 2, it is considered that the silica particles 16 are likely to clog the pores 14 because the silica particles 16 are relatively large while the pore-related areas are small. For this reason, it is presumed that the silica particles 16 were unlikely to be supplied enough to the polishing surface 10a during the polishing process, resulting in the lower polishing rate. Furthermore, if the pore-related areas are too large relative to the silica particles 16, it is considered that the silica particles 16 are likely to come off from the polishing pad 10 quickly when polishing is performed while the polishing liquid 11a is supplied. In this case, it is presumed that the number of the silica particles 16 that acts on the polishing surface 10a is likely to decrease, and the polishing rate is unlikely to increase.

Furthermore, because the polishing pads 10 of Working Examples 1 to 3 each comprise: the base material 12 made of the base resin and having the plurality of the pores 14 formed therein; and the silica particles 16 held in the base material 12 or in the pores 14, the polishing liquid 11a containing no polishing particles were employable. This enables facilitating quality control of the polishing liquid 11a and eliminating or simplifying a process for cleaning the polished wafer 1. In addition, the polishing liquid 11a can be inexpensive, and therefore it is not necessarily required to collect and reuse the polishing liquid 11a that has been used for polishing the wafer. Furthermore, even when the used polishing liquid 11a is discarded, the liquid is not required to be treated complexly.

Consequently, use of the polishing pad 10 of each of Working Examples 1 to 3 in the aforementioned wafer polishing apparatus enables facilitating quality control of the polishing liquid 11a, eliminating or simplifying the separate cleaning process, facilitating treatment of the polishing liquid 11a that has been used for polishing the wafer, and obtaining a high surface quality of the polished wafer 1 and a high polishing rate. Thus, it is possible to further lower the manufacturing cost of semiconductor apparatuses and to reduce the environmental impact.

In addition, the polishing pads 10 of Working Examples 1 to 3 are manufacturable according to the manufacturing method of Working Examples 1 to 3. Furthermore, the wafer polishing method of Working Examples 1 to 3 enables further lowering of the manufacturing cost of semiconductor apparatuses and reduction of the environmental impact.

The present invention has been described above based on Working Examples 1 to 3, but the present invention is not limited to Working Examples 1 to 3 described above and, needless to say, modifications may be applied as appropriate within a scope that does not depart from the spirit of the present invention.

For example, in the polishing pads 10 of Working Examples 1 to 3, the base resin was PES and the solvent was NMP, but it is possible to change the base resin to PVDF or to change the solvent to NMP as long as proportions of the base resin, the silica particles 16, and the solvent are adjusted in the first step such that the pore-related areas have an average value of 87.7 µm² or more.

### INDUSTRIAL APPLICABILITY

The present invention is usable for semiconductor manufacturing apparatuses.

### REFERENCE SIGNS LIST

- O1: axis
- 7b: fixing surface
- 7: surface plate
- 5: carrier
- 1: wafer
- 10: polishing pad
- 11a: polishing liquid
- 12: base material
- 14: pores
- 16: polishing particles

## Claims

1. A polishing pad that is used in a wafer polishing apparatus including: a surface plate having a fixing surface that extends in a direction perpendicular to an axis and being rotated around the axis; and a carrier holding a flat plate-shaped wafer such that the wafer is rotatable relative to the surface plate,
the polishing pad being fixed to the fixing surface and polishing the wafer at a predetermined surface pressure in presence of a polishing liquid, comprising:
a base material made of a base resin and having a plurality of pores formed therein; and polishing particles held in the base material or in the pores,
wherein:
when any specific pores are selected from the pores, and a short diameter, which is the shortest inner diameter of each of the specific pores, and a long diameter, which is the longest inner diameter thereof, are defined,
pore-related areas, each of which is calculated by multiplying the short diameter, the long diameter, pi and 1/4, have an average value of 87.7 µm² or more; and
the polishing particles are silica particles with a specific surface area of 8.9 to 10.5 m²/g.

2. The polishing pad according to claim 1, wherein any of the pore-related areas has a maximum value of 209.3 µm² or more and a minimum value of 29.3 µm² or more.

3. The polishing pad according to claim 1 or 2, wherein the base resin is polyethersulfone.

4. A polishing pad manufacturing method comprising:
a first step of preparing a paste containing a base resin, polishing particles, and a solvent;
a second step of forming the paste into a sheet-shaped formed body;
a third step of immersing the formed body in a replacement liquid and replacing the solvent in the formed body with the replacement liquid to obtain a replaced body; and
a fourth step of removing the replacement liquid from the replaced body to obtain a polishing pad that includes: a base material made of the base resin and having a plurality of pores formed therein; and polishing particles held in the base material or in the pores,
wherein:
the polishing particles are silica particles with a specific surface area of 8.9 to 10.5 m²/g; and
when any specific pores are selected from the pores, and a short diameter, which is the shortest inner diameter of each of the specific pores, and a long diameter, which is the longest inner diameter thereof, are defined,
proportions of the base resin, the polishing particles, and the solvent are adjusted in the first step such that pore-related areas, each of which is calculated by multiplying the short diameter, the long diameter, pi and 1/4, have an average value of 87.7 µm² or more.

5. A wafer polishing method comprising polishing a flat plate-shaped wafer by rotating the wafer and a flat plate-shaped polishing pad relative to each other around an axis that extends in a thickness direction of the wafer while the wafer and the polishing pad are in contact with each other at a predetermined surface pressure in presence of a polishing liquid,
wherein:
the polishing pad includes: a base material made of a base resin and having a plurality of pores formed therein; and polishing particles held in the base material or in the pores;
when any specific pores are selected from the pores, and a short diameter, which is the shortest inner diameter of each of the specific pores, and a long diameter, which is the longest inner diameter thereof, are defined,
pore-related areas, each of which is calculated by multiplying the short diameter, the long diameter, pi and 1/4, have an average value of 87.7 µm² or more; and
the polishing particles are silica particles with a specific surface area of 8.9 to 10.5 m²/g.
